# EUROPEAN PATENT SPECIFICATION

(11) **EP 2 709 142 B1**
(45) Date of publication and mention of the grant of the patent: **23.03.2016**
(21) Application number: 12796409.6
(22) Date of filing: 31.05.2012
(51) Int. Cl.: H01L 29/06, H01L 21/3065

(54) **Method for forming a PN superjunction**
Verfahren zur Bildung eines PN-Superübergangs
Procédé de formation d'une superjonction PN

(30) Priority: 08.06.2011 CN 201110151784
(43) Date of publication of application: 19.03.2014
(73) Proprietor: CSMC Technologies Fab1 Co., Ltd., Wuxi, Jiangsu 214028 (CN); CSMC Technologies Fab2 Co., Ltd., Wuxi City, Jiangsu 214028 (CN)
(72) Inventor: WU, Tzong Shiann, Wuxi Jiangsu 214028 (CN); WANG, Genyi, Wuxi Jiangsu 214028 (CN); YUAN, Leibing, Wuxi Jiangsu 214028 (CN); WU, Pengpeng, Wuxi Jiangsu 214028 (CN)
(74) Representative: Sun, Yiming
(86) International application number: PCT/CN2012/076353
(87) International publication number: WO 2012/167715

(56) References cited:
- CN-A- 101 752 252
- CN-A- 101 752 252
- CN-A- 101 872 724
- CN-A- 101 872 724
- US-B2- 6 399 506

## Description

### FIELD OF THE INVENTION

The present invention relates to the field of semiconductor manufacturing technologies and, more particularly, to a method for manufacturing a deep-trench PN superjunction.

### BACKGROUND OF THE INVENTION

In the field of semiconductor, the PN superjunction technique used to improve the performance of power MOS has become significantly prominent in high-voltage applications.

The conventional fabrication process of PN superjunctions mainly includes deep trench etching, epitaxial filling, and silicon CMP planarizing.

Specifically, the conventional fabrication process of a PN superjunction includes following steps:
Step 1: forming a single thick epitaxial layer (N type) on an N+ silicon substrate;
Step 2: forming deep trenches in the epitaxial layer. Specifically, first forming a thermal oxide layer, then depositing a silicon nitride layer, then depositing a plasma enhanced chemical vapor deposition oxide layer, by etching the above mentioned three layers to the silicon substrate, then removing the photoresist, and use the above mentioned three layers as a hard mask to do an etching process to form deep trenches, then removing the plasma enhanced chemical vapor deposition oxide layer using a wet etching method.
Step 3: forming PN superjunctions by filling the deep trenches with epitaxial silicon (P type).
Step 4: planarizing the surface of the silicon substrate using a CMP process.

However, with respect to the CMP process used herein, because equipment for the CMP process is usually used in the back-end-of-line processing, they cannot be shared with the fabrication process of a PN superjunction. Therefore the conventional fabrication process of a superjunction utilizing the CMP process to obtain planarization often needs dedicated CMP equipment, which causes difficult process control and increased production cost.

The patent application CN 101 752 252 A discloses a forming method of a longitudinal P-type region in a CoolMOS structure. The longitudinal P-type region of the CoolMOS is formed by the steps of: opening a deep groove on a N-type epitaxial layer, then growing P-type monocrystalline silicon inside the groove to form a P-type region in the N-type epitaxial layer by using epitaxy, and then etching the P-type monocrystal growing in the groove to be parallel and level with the surface of the groove by using an etchback technology. The method reduces the complexity and the processing time of the technology.

The patent application CN 101 872 724 discloses a manufacturing method of a superjunction MOSFET (Metal-Oxide-Semiconductor Field-Effect Transistor), which comprises the following steps of: when filling a groove, firstly filling a P-type epitaxial region into the groove, and then filling the groove by utilizing polycrystalline silicon; and then finishing subsequent process steps. A P-type thin layer structure is formed by firstly filling the groove through the P-type epitaxial region and then filling the groove by utilizing the polycrystalline silicon, the complexity of a groove filling process can be reduced by utilizing the better groove filling capability of the polycrystalline silicon, and the cost of the process is lowered by utilizing the high-batch processing capability of the polycrystalline silicon.

### SUMMARY OF THE INVENTION

Based on the above-mentioned problems, the objective of the present invention is to provide a method for manufacturing PN supperjunctions which would be compatible with the conventional fabrication process, and would have high production efficiency.

According to the present invention a method for forming a PN superjunction is defined in claim 1 and includes:
a deposition step for forming an N-type epitaxial layer on a substrate;
a dielectric forming step for forming a first dielectric layer and a second dielectric layer in sequence on the epitaxial layer;
a deep trench forming step for forming deep trenches in the epitaxial layer;
a first filling step for completely filling the deep trenches to beyond the second dielectric layer with a P-type epitaxial material;
a second filling step for forming a surface filling layer by filling the entire surface of the second dielectric layer and the epitaxial layer using a filling dielectric, wherein the surface filling layer extends up to a height at least higher than a highest point of the epitaxial material;
an etching step for etching back the surface filling layer and the epitaxial material to the interface of the first dielectric layer and the epitaxial layer; and
a removing step for removing the first dielectric layer and the second dielectric layer to planarize the epitaxial layer.

Preferably, in the above mentioned etching step, a plasma etching process is used.

Preferably, in the second filling step, the above mentioned filling dielectric is a flowable dielectric.

By using the present invention to substitute the CMP of the existing technique, and also using the flowable dielectric and a plasma etch back process, therefore, the problems caused by utilizing the CMP to planarize, such as more complex process, more difficult process control and high production cost, can be effectively solved.

Preferably, the plasma etching process can be controlled by adjusting the etching rate selectivity ratio to obtain an etching rate selectivity ratio of 1:1 for the epitaxial material and the third dielectric.

Preferably, in the second filling step, the flowable filling dielectric completely fills the entire surface of the second dielectric layer and the epitaxial material using a spin-coating process.

Preferably, in the removing step, a wet process is used to remove the first and second dielectric layers.

Preferably, in the first filling step, a lowest point of the epitaxial material is higher than the interface of the first dielectric layer and the epitaxial material.

Preferably, the material of the first dielectric layer is oxide, the material of the second dielectric layer is nitride, and the filling dielectric is SOG.

The epitaxial material may be Si.

Preferably, a thickness of the first dielectric layer is greater than 50 nm (500 A), and a thickness of the second dielectric layer is greater than 30 nm (300 Å).

As described above, by filling the flowable dielectric material and using the plasma etch back process, silicon planarization can be achieved using the processes compatible with the existing fabrication process, without dedicated CMP equipment. Thus, the disclosed method has the advantages of simple process, high efficiency and low cost, and can avoid the unstable problems of Si devices caused by using the CMP process.

### BRIEF DESCRIPTION OF THE DRAWINGS

Figure 1 illustrates an overall schematic flow diagram of a PN superjunction fabrication process consistent with one embodiment of the present invention;
Figure 2 illustrates a breakdown structure diagram of a PN superjunction fabrication process consistent with one embodiment of the present invention;
Figure 3 illustrates a breakdown structure diagram of a PN superjunction consistent with one embodiment of the present invention;
Figure 4 illustrates a breakdown structure diagram of a PN superjunction fabrication process consistent with one embodiment of the present invention; and
Figure 5 illustrates a breakdown structure diagram of a PN superjunction fabrication process consistent with one embodiment of the present invention.

### DETAILED DESCRIPTION OF THE INVENTION

The followings describe certain embodiments among various possible embodiments, for the purpose of providing the basic aspects of the present invention. They are not intended to confirm any necessary and/or decisive elements of the present invention, or to limit the protection scope of the present invention as set out in the appended claims.

In order to illustrate more clearly the purpose, the technical solutions, and the advantages of the present invention, details will be described with accompanying drawings in the followings.

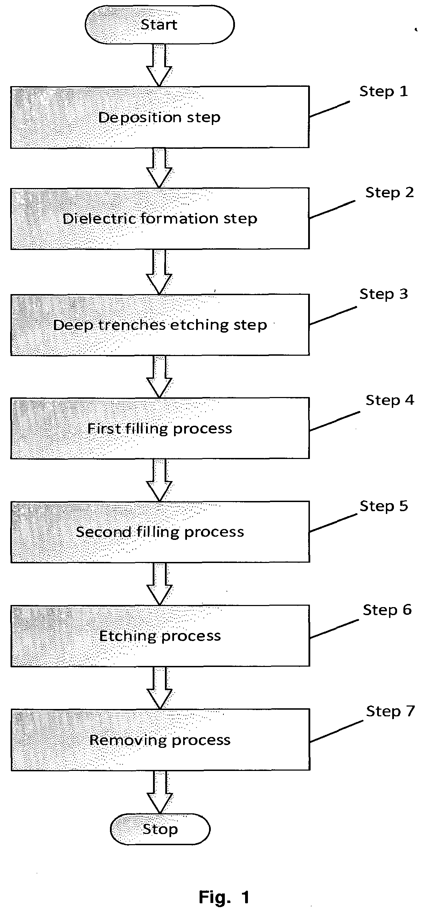

Followings, as shown in Figures 1-5, are descriptions of a fabrication process of a deep trench PN superjunction consistent with the disclosed embodiments.

Figure 1 illustrates an overall schematic flow diagram of a method for manufacturing a PN superjunction consistent with one embodiment of the present invention.

Firstly, as shown in Figure 1, in one embodiment, the method for manufacturing a PN superjunction of the present invention mainly includes:
Step 1: a deposition step for forming an N-type epitaxial layer on a substrate;
Step 2: a dielectric forming step for forming the first dielectric layer and the second dielectric layer in sequence on the epitaxial layer;
Step 3: a deep trench forming step for forming deep trenches in the epitaxial layer;
Step 4: a first filling step for completely filling the trenches to beyond the second dielectric layer with a P-type epitaxial material;
Step 5: a second filling step for forming a surface filling layer by completely filling the second dielectric layer and the epitaxial layer using a filling dielectrics;
Step 6: an etching step to etch back the surface filling layer and the epitaxial material to the interface of the first dielectric layer and the epitaxial layer; and
Step 7: a removing step to remove the first dielectric layer and the second dielectric layer to planarize the epitaxial layer.

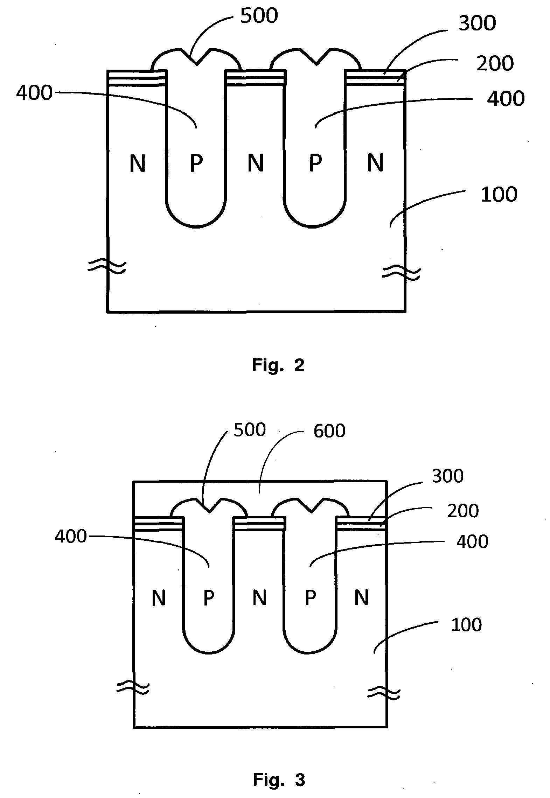

Figures 2-5 illustrate breakdown schematic diagrams of a method for manufacturing a PN superjunction consistent with disclosed embodiments of the present invention.

The followings describe in detail the Steps 1-7 with references to Figures 2-5.

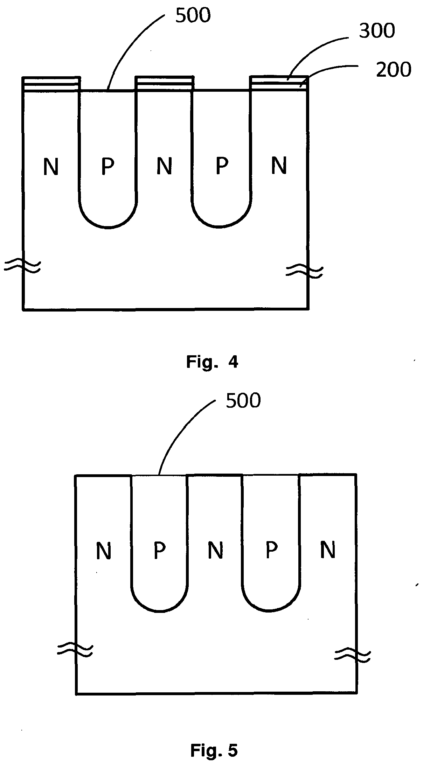

As shown in Figures 2-5, the method for manufacturing a PN superjunction consistent with one embodiment of the present invention mainly includes following steps:
Step 1: forming a N-type epitaxial layer 100 on a substrate;
Step 2: forming the first dielectric layer 200 and the second dielectric layer 300 in sequence on the epitaxial layer 100;
Step 3: forming deep trenches 400 in the epitaxial layer;
Step 4: as shown in Figure 2, completely filling the trenches 400 to beyond the second dielectric layer 300 with a P-type epitaxial material 500;
Step 5: as shown in Figure 3, covering and completely filling the entire surface of the second dielectric layer 300 and the epitaxial material 500 using a filling dielectric 600, and forming a surface filling layer extending up to a height at least higher than a highest point of the epitaxial material 500;
Step 6: as shown in Figure 4, etching back the surface filling layer and the epitaxial material to the interface of the first dielectric layer 200 and the epitaxial layer 100; and
Step 7: removing the first dielectric layer 200 and the second dielectric layer 300 to planarize the epitaxial layer.

Therefore, by filling the filling dielectric and using the etch back process to substitute the CMP process of the existing fabrication process, the problems caused by utilizing the CMP process for planarization, such as process complexity, difficult process control and high production cost, can be effectively be solved.

Further, other modified embodiments are also described below.

The third dielectric 600 is preferably a flowable material. For example, the third dielectric 600 can be SOG. So, in the Step 5, the entire surface of the second dielectric layer 300 and epitaxial material 500 shown in Figure 2 can be completely filled with the flowable third dielectric 600 such as SOG to form the surface filling layer extending up to a height at least higher than a highest point of the epitaxial material 500.

Any appropriate accessory equipment can be used to fill the third dielectric 600. When using the accessory equipment to fill the third dielectric 600, the accessory equipment may spin and coat the flowable third dielectric 600 to completely fill the entire surface.

In the step 6, as an etch back process, a plasma etching process may be used. In the plasma etching process, in order to obtain a flat etching of both the epitaxial material 500 and the filling dielectric 600, the etching rate selectivity ratio, for the epitaxial material 500 and the filling dielectric 600, for example, can be adjusted as 1:1. Thus, the same etching speed can be used to etch the epitaxial material 500 and the filling dielectric 600 to ensure the flatness of the etched materials, and to achieve a planarization of the epitaxial material.

Here, Si may often be used as the epitaxial material 500. Further, in the Step 7, as a wet etching process may often be used to remove the first dielectric layer 200 and the second dielectric layer 300.

In addition, the first dielectric layer 200 herein may be made of oxide. The second dielectric layer 300 may be made of nitride. The thickness of the first dielectric layer is greater than 50 nm (500 Å), and the thickness of the second dielectric layer is greater than 30 nm (300 Å).

Thus, by using the present invention, because the epitaxial material is planarized by a method compatible with the existing fabrication process, the process is simple, the efficiency is high and no dedicated equipment is needed (CMP equipment). Therefore, the process cost is significantly reduced, and the unstable problems of Si devices caused by CMP the process can be effectively avoided.

The above examples mainly describe the fabrication process of a PN superjunction.

## Claims

1. A method for forming a PN superjunction, comprising:
a deposition step for forming an N-type epitaxial layer (100) on a substrate;
a dielectric forming step for forming a first dielectric layer (200) and a second dielectric layer (300) in sequence on the epitaxial layer (100);
a deep trench forming step for forming deep trenches (400) in the epitaxial layer (100);
a first filling step for completely filling the deep trenches (400) to beyond the second dielectric layer (300) with a P-type epitaxial material (500);
a second filling step for forming a surface filling layer by filling the entire surface of the second dielectric layer (300) and the epitaxial layer (100) using a filling dielectric (600), wherein the surface filling layer extends up to a height at least higher than a highest point of the epitaxial material (500);
an etching step for etching back the surface filling layer and the epitaxial material (500) to the interface of the first dielectric layer (200) and the epitaxial layer (100); and
a removing step for removing the first dielectric layer (200) and the second dielectric layer (300) to planarize the epitaxial layer (100).

2. The method according to claim 1, wherein:
in the etching step, a plasma etching process is used.

3. The method according to claim 2, wherein:
the plasma etching process adjusts an etching rate selectivity ratio to obtain an etching rate selectivity ratio of 1:1 for the epitaxial material and the filling dielectric.

4. The method according to claim 2, wherein:
in the second filling step, the filling dielectric is a flowable dielectric.

5. The method according to claim 4, wherein:
in the second filling step, the flowable filling dielectric completely fills an entire surface of the second dielectric layer and the epitaxial material using a spin-coating process.

6. The method according to claim 4, wherein:
in the removing step, a wet process is used to remove the first dielectric layer and the second dielectric layer.

7. The method according to claim 4, wherein:
in the first filling step, a lowest point of the epitaxial material is higher than the interface of the first dielectric layer and the epitaxial material.

8. The method according to any one of claims 1-7, wherein:
the material of the first dielectric layer is oxide, the material of the second dielectric layer is nitride, and the filling dielectric is SOG.

9. The method according to claim 8, wherein:
a thickness of the first dielectric layer is greater than 50 nm (500 Å), and a thickness of the second dielectric layer is greater than 30 nm (300 Å).

## Patentansprüche

1. Verfahren zur Bildung einer PN-Superjunction, umfassend:
einen Ablagerungsschritt zur Bildung einer N-Typ-Epitaxialschicht (100) auf einem Substrat;
einen Dielektrikum-Bildungsschritt zur Bildung einer ersten Dielektrikumschicht (200) und einer zweiten Dielektrikumschicht (300) in Schrittkette auf der Epitaxialschicht (100);
einen Bildungsschritt für tiefe Gräben zur Bildung von tiefen Gräben (400) in der Epitaxialschicht (100);
einen ersten Füllschritt zur vollständigen Füllung der tiefen Gräben (400) bis jenseits der zweiten dielektrischen Schicht (300) mit einem P-Typ-Epitaxialmaterial (500);
einen zweiten Füllschritt zur Bildung einer Flächenfüllschicht durch Befüllung der gesamten Fläche der zweiten Dielektrikumschicht (300) und der Epitaxialschicht (100) mit einem Fülldielektrikum (600), wobei sich die Flächenfüllschicht bis zu einer Höhe erstreckt, die mindestens höher ist als einen höchsten Punkt des Epitaxialmaterials (500);
einen Ätzschritt zum Zurückätzen der Flächenfüllschicht und des Epitaxialmaterials (500) auf die Schnittstelle der ersten Dielektrikumschicht (200) und der Epitaxialschicht (100); und
einen Entfernungsschritt zum Entfernen der ersten Dielektrikumschicht (200) und der zweiten Dielektrikumschicht (300), um die Epitaxialschicht (100) zu planieren.

2. Verfahren nach Anspruch 1, wobei
im Ätzschritt ein Plasma-Ätzprozess angewendet wird.

3. Verfahren nach Anspruch 2, wobei
der Plasma-Ätzprozess ein Ätzraten-Selektivitätsverhältnis einstellt, um ein Ätzraten-Selektivitätsverhältnis von 1:1 für das Epitaxialmaterial und das Fülldielektrikum zu erzielen.

4. Verfahren nach Anspruch 2, wobei im zweiten Füllschritt das Fülldielektrikum ein fließfähiges Dielektrikum ist.

5. Verfahren nach Anspruch 4, wobei
im zweiten Füllschritt das fließfähige Fülldielektrikum eine gesamte Fläche der zweiten Dielektrikumschicht und des Epitaxialmaterials mittels eines Spin-Coating-Prozesses vollständig füllt.

6. Verfahren nach Anspruch 4, wobei
im Entfernungsschritt ein Nassverfahren zum Entfernen der ersten Dielektrikumschicht und der zweiten Dielektrikumschicht angewendet wird.

7. Verfahren nach Anspruch 4, wobei
im ersten Füllschritt ein tiefster Punkt des Epitaxialmaterials höher ist als die Schnittstelle der ersten Dielektrikumschicht und des Epitaxialmaterials.

8. Verfahren nach einem der Ansprüche 1-7, wobei:
das Material der ersten Dielektrikumschicht Oxid ist, das Material der zweiten Dielektrikumschicht Nitrid ist und die Füllung SOG ist.

9. Verfahren nach Anspruch 8, wobei
eine Dicke der ersten Dielektrikumschicht größer ist als 50 nm (500 Ä) und eine Dicke der zweiten Dielektrikumschicht größer ist als 30 nm (300 Å).

## Revendications

1. Procédé de formation d'une superjonction PN, comprenant :
une étape de dépôt pour la formation d'une couche épitaxiale dopée de type N (100) sur un substrat ;
une étape de formation de diélectrique pour la formation d'une première couche de diélectrique (200) et une deuxième couche de diélectrique (300) en séquence sur la couche épitaxiale (100) ;
une étape de formation de tranchée profonde pour la formation de tranchées profondes (400) dans la couche épitaxiale (100) ;
une première étape de remplissage pour le remplissage complet des tranchées profondes (400) jusqu'au-delà de la deuxième couche de diélectrique (300) avec un matériau épitaxial dopé de type P (500) ;
une deuxième étape de remplissage pour la formation d'une couche de remplissage de surface en remplissant la surface entière de la deuxième couche de diélectrique (300) et la couche épitaxiale (100) à l'aide d'un diélectrique de remplissage (600), dans laquelle la couche de remplissage de surface s'étend jusqu'à une hauteur au moins supérieure à un point culminant du matériau épitaxial (500) ;
une étape de gravure pour la gravure en retour de la couche de remplissage de surface et du matériau épitaxial (500) à l'interface de la première couche de diélectrique (200) et la couche épitaxiale (100) ; et
une étape d'enlèvement pour l'enlèvement de la première couche de diélectrique (200) et la deuxième couche de diélectrique (300) afin d'aplanir la couche épitaxiale (100).

2. Procédé selon la revendication 1, dans lequel :
à l'étape de gravure, un processus de gravure de plasma est utilisé.

3. Procédé selon la revendication 2, dans lequel :
le processus de gravure de plasma ajuste un rapport de sélectivité de vitesse de gravure pour obtenir un rapport de sélectivité de vitesse de gravure de 1:1 pour le matériau épitaxial et le diélectrique de remplissage.

4. Procédé selon la revendication 2, dans lequel : à la deuxième étape de remplissage, le diélectrique de remplissage est un diélectrique fluide.

5. Procédé selon la revendication 4, dans lequel :
à la deuxième étape du remplissage, le diélectrique de remplissage fluide remplit complètement une surface entière de la deuxième couche de diélectrique et du matériau épitaxial au moyen d'un procédé de revêtement par centrifugation.

6. Procédé selon la revendication 4, dans lequel :
à l'étape d'enlèvement, on utilise un procédé humide pour enlever la première couche de diélectrique et la deuxième couche de diélectrique.

7. Procédé selon la revendication 4, dans lequel :
à la première étape de remplissage, un point le plus bas du matériau épitaxial est supérieur à l'interface de la première couche de diélectrique et du matériau épitaxial.

8. Procédé selon l'une quelconque des revendications 1-7, dans lequel :
le matériau de la première couche de diélectrique est l'oxyde, le matériau de la seconde couche de diélectrique est le nitrure et le diélectrique de remplissage est le SOG.

9. Procédé selon la revendication 8, dans lequel :
une épaisseur de la première couche de diélectrique est supérieure à 50 nm (500 Å) et une épaisseur de la deuxième couche de diélectrique est supérieure à 30 nm (300 À).
